# EUROPEAN PATENT APPLICATION

(11) **EP 1 326 280 A1**
(43) Date of publication of application: **09.07.2003**
(21) Application number: 02769610.3
(22) Date of filing: 16.05.2002
(51) Int. Cl.: H01L 29/78, H01L 21/336

(54) **CHANNEL GATE TYPE FIELD EFFECT TRANSISTOR AND ITS MANUFACTURING METHOD**

(30) Priority: 17.05.2001 JP 2001147878
(71) Applicant: Sony Corporation, Tokyo 141-0001 (JP)
(72) Inventor: SUZUKI, Toshiharu, c/o SONY CORPORATION, Tokyo 141-0001 (JP)
(74) Representative: Müller, Frithjof E., Dipl.-Ing.
(86) International application number: JP0204723
(87) International publication number: WO02093651

(57) **Abstract**

In achieving miniaturization and a large scale integration of a transistor, the operating speed can be increased by effectively suppressing a short channel effect, and reducing the capacitance between a drain or a source and a gate. A method of manufacturing a trench gate type field effect transistor comprises forming an impurity layer (9), which is to be a source or a drain, in a semiconductor substrate (1), forming a first trench (20) in this semiconductor substrate (1), forming a side wall (21) made of an insulating material on a side wall of the first trench (20), forming a second trench (22) in a bottom surface of the first trench with the side wall (21) as a mask, forming a gate insulating film (5) on a bottom surface of the second trench (22), and forming a gate (G) so as to fill the second trench (22) and the first trench (20).

## Description

### TECHNICAL FIELD

The present invention relates to a trench gate type field effect transistor which accommodates miniaturization and is capable of suppressing short channel effect.

### BACKGROUND ART

MOS type LSIs using a silicon substrate are currently in a phase where LSIs with 0.18-µm design rules (design criteria) are shifting into mass production, but further improvements are demanded in the degree of integration through miniaturization, and LSIs of 0.13-µm to 0.10-µm design rules are under development. Higher operating speed and lower power consumption are also demanded of these LSIs.

When an LSI is miniaturized to make the degree of integration larger in scale, suppressing the short channel effect becomes an extremely important issue in suppressing deviations in the performance of individual transistors. Thus, in MOS type field effect transistors already put to practical use in which a gate is formed on a semiconductor substrate, and a source and a drain are formed in a self-aligned manner with respect to the gate, optimization of the impurity concentration, shape of the source and the drain, and the well impurity profile of a channel area, and the like is achieved. Further, at an end of the source or the drain, forming an impurity area, commonly referred to as a Halo or a pocket, of an opposite conductivity type by way of methods such as oblique ion implantation or the like to suppress the short channel effect is being attempted. However, because the optimization of multiple parameters requires enormous efforts, it is said that development and mass production thereof requires a significant period of time. Also, it cannot be said that the short channel effect is sufficiently suppressed either.

In addition, in miniaturized transistors of post-0.1-µm design rules, it is difficult to achieve transistor performance which is in accord with the trend for miniaturization, and the adopting of a new material is needed. For example, in transistors of post-0.1-µm design rules, since a gate insulating film is equivalent to 2 nm or below of a silicon oxide film and becomes a direct tunnel current area of the silicon oxide film, adopting a high dielectric constant insulating film to replace the silicon oxide film as the gate insulating film is becoming necessary.

In addition, when a gate is formed of conventional polysilicon, because depletion occurs in the gate itself, and becomes an impediment to improvements in the performance of the transistor, adopting a metal material such as Tin or Mo as the material for forming the gate is being needed. However, because such metal materials cannot withstand the heat treatment during the formation of a source and a drain in the conventional method of manufacturing a transistor in which the source and the drain are formed in a self-aligned manner with respect to a gate, the adoption of the conventional transistor manufacturing method is precluded.

As such, as a transistor forming technique for forming the gate with a metal material, a so-called damascene gate transistor is proposed.

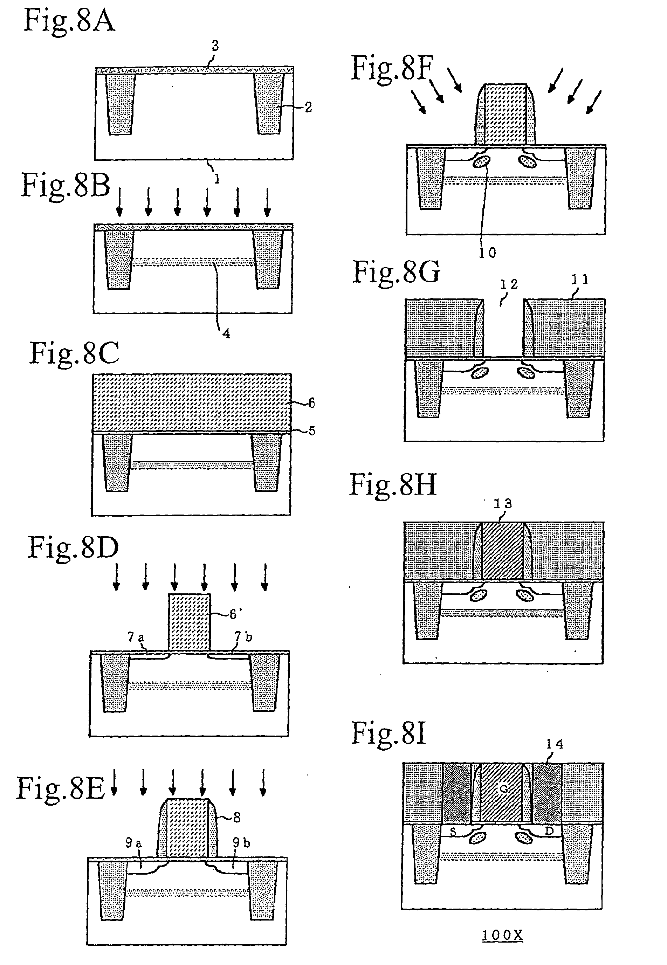

Fig. 8A to Fig. 8I are explanatory views of the steps of a method of manufacturing an n-type transistor 100X with the damascene gate method.

In this method, first, element separators 2 are formed in a p-type silicon substrate 1, and a through-film 3 comprising SiO₂ or the like is further formed (Fig. 8A). A well 4 and a Vₜₕ adjusting layer (not shown) are each formed by performing ion implantation through the through-film 3 (Fig. 8B). Next, after the through-film 3 is removed, a gate insulating film 5 of approximately 3 to 5 nm is formed through a thermal oxidation at 1000°C for approximately 30 minutes, and a polysilicon 6 of approximately 500 nm in thickness, which becomes a dummy gate, is deposited thereon through low-pressure CVD or the like (Fig. 8C). Thereafter, lithography technology and etching technology are used to form a gate pattern (dummy gate) 6' of a desired design rule. Then with this gate pattern 6' as a mask, impurities such as arsenic, which become an extended source 7a and an extended drain 7b, are implanted at 10 keV and approximately 1 x 10¹⁵ cm⁻² as per the arrows (Fig. 8D). Next, an SiO₂ film is deposited by a normal CVD method and by forming a side wall 8 through anisotropic etching and performing ion implantation again, approximately 3 x 10¹⁵ cm⁻² of arsenic, which forms an impurity layer which is to become a source S and a drain D, is introduced at 30 keV (Fig. 8E).

Next, to form a pocket (Halo) 10 for suppressing the short channel effect, a p-type impurity such as arsenic is ion-implanted at an angle of 10° to 30° with respect to the normal to the substrate surface at 20 kev and approximately 1 x 10¹³ cm⁻² (Fig. 8F). Then, to activate the impurities introduced into the substrate 1 up to this point, annealing is performed at 900°C for approximately 30 minutes in an electric furnace, or at 1050°C for approximately 10 seconds by a rapid heating method.

Thereafter, an interlayer insulating film 11 of SiO₂ or the like is deposited by the CVD method. Next, the interlayer insulating film 11 is polished through CMP until the dummy gate 6' is exposed, and further, the dummy gate 6' is removed through etching to form a trench 12 (Fig. 8G).

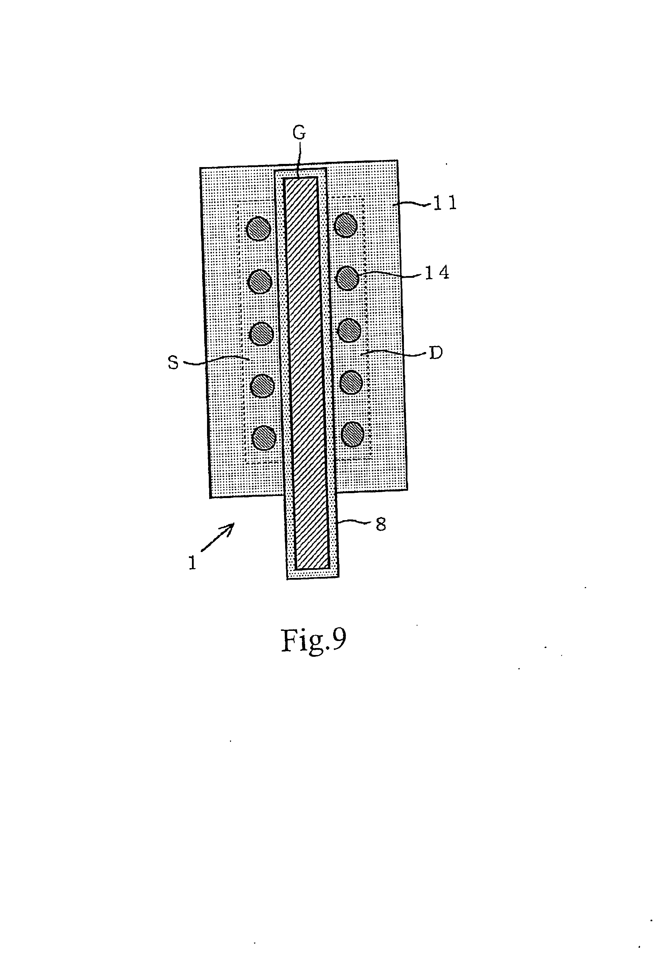

A metal 13 which is to become a real gate G is embedded in the trench 12 through a sputtering method or the CVD method, planarization is performed again through CMP (Fig. 8H), and lead electrodes 14 of the source and the drain are formed (Fig. 8I) to obtain the transistor 100X. Fig. 9 is a top view of the transistor 100X obtained in this manner.

It should be noted that, in the formation of a transistor by this damascene gate method, to enhance the reliability of the gate insulating film 5, instead of forming the gate insulating film 5 before the formation of the dummy gate 6', it is preferable that it be formed through thermal oxidation after the dummy gate 6' is removed. In addition, when a high dielectric constant insulating film is formed as the gate insulating film 5, it is preferable that a high dielectric constant insulating film of ZrO₂, Al₂O₃ or the like be formed through the sputtering method or the CVD method in the trench 12 after the dummy gate 6' is removed.

By performing the formation of the gate insulating film comprising a high dielectric constant insulating film or the formation of the gate comprising a metal material after the annealing for activating the impurities, changes in the properties of the high dielectric constant insulating film or the gate due to the heat during annealing, or the reacting of the high dielectric constant insulating film or the gate with the upper or lower layer can be suppressed to a minimum. Therefore, by forming the gate insulating film with a high dielectric constant insulating film having a thick film thickness, direct tunnel currents, which become a problem when the gate insulating film is formed with a silicon oxide film, may be prevented. In addition, by forming the gate with a metal material, depletion in the gate, which becomes a problem when the gate is formed with polysilicon, may be prevented.

However, even with the damascene method, the short channel effect cannot be reduced as much as or more than is done in transistors of a conventional structure. Also, while the number of masks required in forming a transistor with this method does not differ from that in the conventional transistor manufacturing method in which the source and the drain are formed in a self-aligned manner with respect to the gate, there is a problem in that the number of steps increases due to the formation and the removal of the dummy gate.

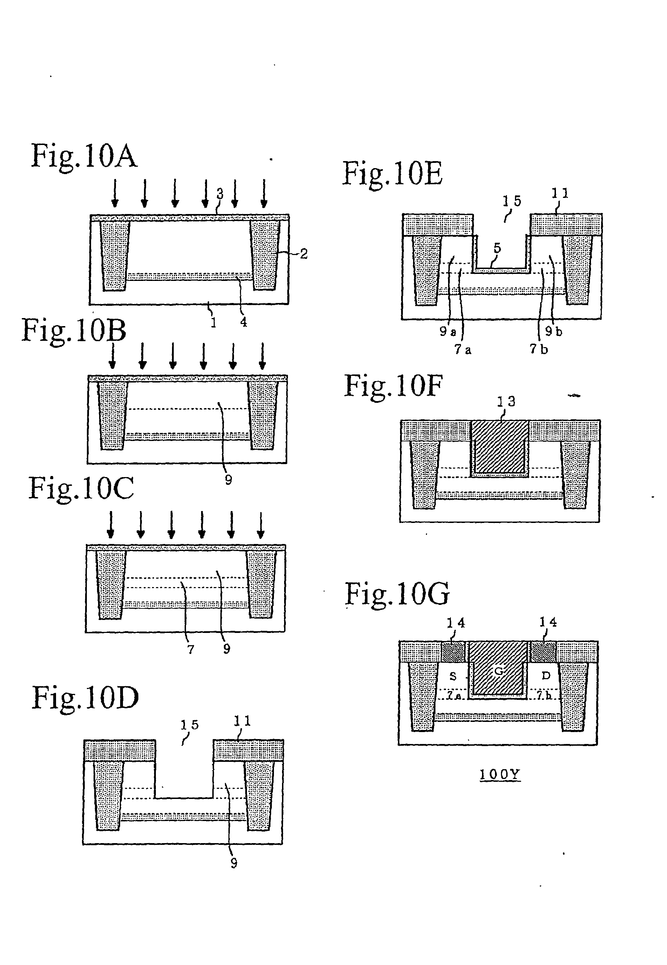

To this end, a trench gate type transistor is proposed in order to suppress the short channel effect. Fig. 10A to Fig. 10G are explanatory diagrams of the steps of a method of manufacturing a trench gate type transistor 100Y.

In this method, element separators 2 such as shallow trenches are formed in a p-type silicon substrate 1, and a through-film 3 comprising SiO₂ or the like is formed. Ions are implanted as per the arrows through the through-film 3 to individually form a well and a Vₜₕ well 4 (Fig. 10A).

Next, phosphorus, arsenic or the like, which are n-type impurities, is ion-implanted as per the arrows at 50 keV and approximately 3 x 10¹⁵ cm⁻² to form an impurity layer 9 which is to configure a source S and a drain D (Fig. 10B). In addition, to form an impurity layer 7 which is to configure an extended source 7a and an extended drain 7b, an n-type impurity of approximately 1 x 10¹⁵ cm⁻² is implanted at an energy slightly higher than that for the ion implantation to form the impurity layer 9 which configures the source S and the drain D (Fig. 10C). Then, to activate the impurities introduced into the substrate 1 up to this point, annealing is performed at 900°C for approximately 30 minutes in an electric furnace, or at 1050°C for approximately 10 seconds by the rapid heating method.

Next, an interlayer insulating film 11 of SiO₂ or the like is deposited with the CVD method. Subsequently, lithography technology and dry etching technology are used to form a trench 15, which is to configure a gate, down to the end of the impurity layer 9, which is to configure the source and the drain or up to several ten nanometers deeper than the end (Fig. 10D).

Then, a gate insulating film 5 of approximately 3 to 5 nm is grown on the bottom surface and the side surface of the trench 15 through thermal oxidation at 1000°C for approximately 30 minutes (Fig. 10E), and into this trench 15, polysilicon/tungsten silicide or a metal 13 such as TiN or Mo, which becomes a metal gate, is filled with the CVD method or the sputtering method (Fig. 10F).

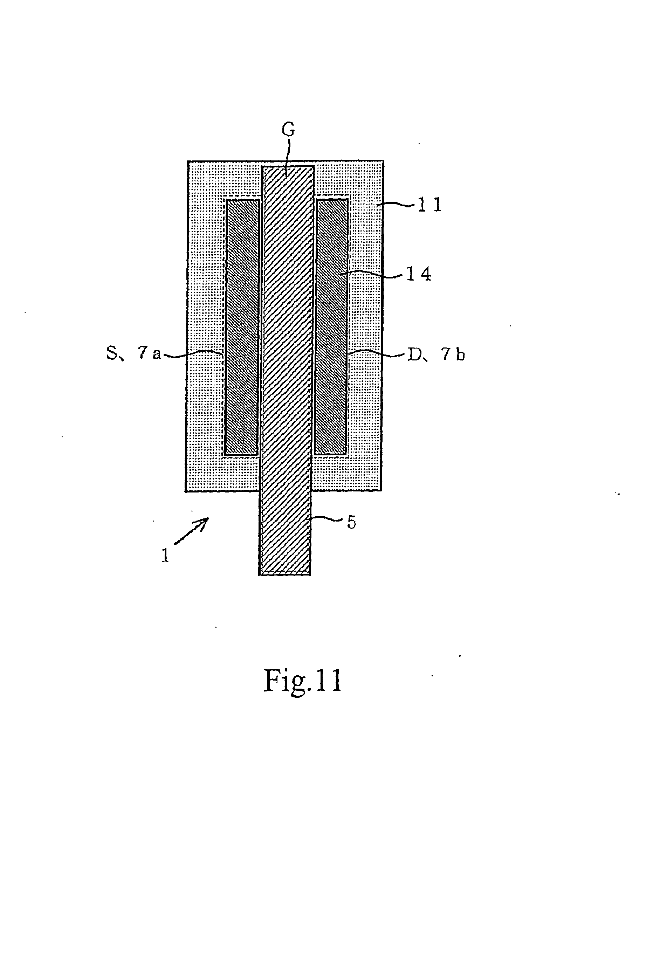

Finally, lead electrodes 14 of the source S and the drain D are formed, and the trench gate type transistor 100Y is obtained (Fig. 10G). Fig. 11 is a top view of this trench gate type transistor 100Y.

In the structure of this trench gate type transistor, since the distance between the source S and the drain D is longer than the gate length, and the source S does not directly face the drain D, the short channel effect is less likely to occur. Also, since the short channel effect is not produced even when the source S and the drain D are thickly formed, by forming them thickly, reductions in the resistances of the source S and the drain D and a reduction in the leakage from the latter formation of the silicide can be achieved. In addition, the trench gate type transistor has the advantage that it can be manufactured with fewer steps as compared with the conventional transistor in which the source and the drain are formed in a self-aligned manner with respect to the gate.

In a trench gate type transistor, however, as shown in Fig. 11, because the gate G faces the source S, the extended source 7a, the drain D, and the extended drain 7b over a wide area via the extremely thin gate insulating film 5, there arises a problem in that the capacitance between the drain D or the source S and the gate G is significantly larger as compared to the damascene gate transistor 100X shown in Fig. 8A to Fig. 8I.

In addition, the effective gate length of a trench gate type transistor tends to be longer than the design rules defined by the lithography resolving power. For this reason, trench gate type transistors are not suitable for the object of achieving an operating speed of ultra high speed.

As opposed to conventional MOS or MIS transistors described above, the object of the present invention is, in order to achieve miniaturization and large-scale integration of field effect transistors, to form a gate with a metal material, andto be able to accommodate the formation of a gate insulating film with a high dielectric constant insulator, and further, to be able to increase the operating speed by effectively suppressing the short channel effect and to reduce the capacitance between a drain or a source and the gate.

### DISCLOSURE OF THE INVENTION

The present inventor has found that, in a structure of a trench gate type field effect transistor suitable for the formation of a gate comprising a metal material or the formation of a gate insulating film comprising a high dielectric constant insulating film, when a side wall is formed in a trench into which a gate is to be embedded, while a second trench is formed in the bottom surface of that trench with the side wall as a mask, a gate insulating film is formed on the bottom surface of this second trench, and the gate is formed to fill these trenches, because a source and a drain do not face each other and a long range can be secured therebetween, the short channel effect can be suppressed effectively, ultra miniaturization of the transistor becomes possible, further, since the capacitance between the source or the drain and the gate is greatly reduced by the side wall, the operating speed can be increased and the performance of the transistor can be drawn out more effectively.

More specifically, the present invention provides a trench gate type field effect transistor comprising a side wall comprising an insulating material and formed on a side wall of a first trench formed in a semiconductor substrate having an impurity layer, a gate insulating film provided on a bottom surface of a second trench formed in a bottom surface of the first trench, a gate formed so as to fill the first trench and the second trench, and a source and a drain formed with said impurity layer and which faces the gate through the side wall.

In addition, the present invention provides, as a method of manufacturing such a trench gate type field effect transistor, a method of manufacturing a trench gate type field effect transistor characterized in that an impurity layer which becomes a source or a drain is formed in a semiconductor substrate, a first trench is formed in the semiconductor substrate, a side wall comprising an insulating material is formed on a side wall of the first trench, a second trench is formed in a bottom surface of the first trench with the side wall as a mask, a gate insulating film is formed on a bottom surface of the second trench, and a gate is formed so as to fill the second trench and the first trench.

### BRIEF DESCRIPTION OF THE DRAWINGS

Fig. 1A to Fig. 1H are explanatory views of the steps of a method of manufacturing a transistor of an embodiment;
Fig. 2A to Fig. 2I are explanatory views of the steps of a method of manufacturing a transistor of an embodiment;
Fig. 3A to Fig. 3I are explanatory views of the steps of a method of manufacturing a transistor of an embodiment;
Fig. 4A to Fig. 4J are explanatory views of the steps of a method of manufacturing a transistor of an embodiment;
Fig. 5A to Fig. 5D are explanatory views of the steps of a method of manufacturing a transistor of an embodiment;
Fig. 6 is a sectional view of a transistor of an embodiment;
Fig. 7A to Fig. 7J are explanatory views of the steps of a method of manufacturing a transistor of an embodiment;
Fig. 8A to Fig. 8I are explanatory views of the steps of a method of manufacturing a conventional damascene gate transistor;
Fig. 9 is a top view of the conventional damascene gate transistor;
Fig. 10A to Fig. 10G are explanatory views of the steps of a method of manufacturing a conventional trench gate type transistor; and
Fig. 11 is a top view of the conventional trench gate type transistor.

### BEST MODE FOR CARRYING OUT THE INVENTION

The present invention is hereinafter described in specific terms with reference to the drawings. In the respective drawings, the same reference numerals represent the same or equivalent elements.

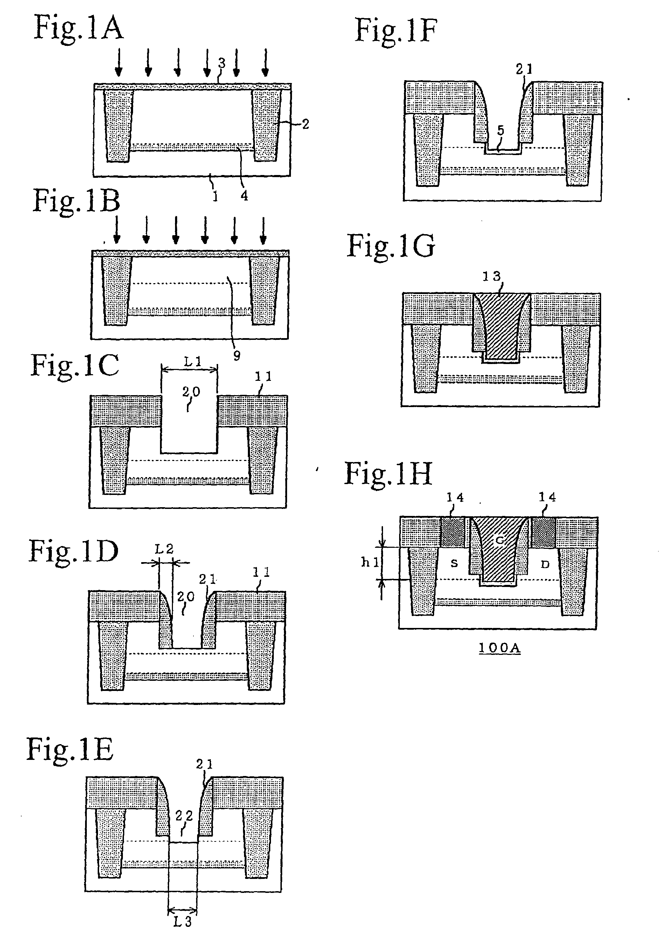

Fig. 1A to Fig. 1H are explanatory views of the manufacturing steps in an embodiment of the present invention for forming an n-type trench gate type MOS (MIS) transistor with an effective gate length of approximately 0.1 µm.

In the present embodiment, first, as in the manufacturing method for the conventional trench gate type transistor 100Y shown in Fig. 10A to Fig. 10G, element separators 2 such as shallow trenches are formed in a p-type silicon substrate 1 at intervals of approximately 0.34 µm, a through-film 3 comprising SiO₂ or the like is further formed, and a well 4 and a Vₜₕ adjusting layer (not shown) are each formed by implanting ions through the through-film 3 (Fig. 1A).

Next, an impurity layer 9 is formed by ion implanting phosphorus, arsenic or the like, which are n-type impurities, at a concentration of approximately 3 x 10¹⁵ cm⁻² with a depth of approximately 0.1 to 0.2 µm in an area in which a source S and a drain D are to be formed (Fig. 1B).

In addition, on the through-film 3, an interlayer insulating film 11 of approximately 0.2 to 0.3 µm comprising SiO₂ or the like is deposited with the CVD method or the like, and annealing is performed thereon at 900°C for approximately 30 minutes in an electric furnace, or at 1050°C for approximately 10 seconds by a rapid heating method to activate the impurities implanted into the substrate 1 up to this point. Then, for example, with lithography technology using KrF laser or the like, a first trench 20 having awidth L1 of approximately 0.18 µm is formed in substantially the center between the element separators 2 to a depth penetrating the interlayer insulating film 11 and shallower than the end of the profile of the impurity layer 9 by several ten nanometers (Fig. 1C).

Next, the CVD method is combined with anisotropic etching, and a side wall 21 comprising an insulating material such as SiO₂ is formed on the side wall of the first trench 20 with a thickness L2 of approximately 0.05 µm, while at the same time the substrate 1 is exposed at the bottom surface of the first trench 20 (Fig. 1D).

With this side wall 21 as a mask, by performing selective etching on the substrate 1 exposed at the bottom surface of the first trench 20 using an etching gas such as HBr which etches silicon but does not etch silicon oxide films, a second trench 22 is formed up to the depth of the end of the profile of the impurity layer 9 or up to a depth deeper than that end by several ten nanometers (Fig. 1E).

Next, by thermally oxidizing the bottom surface of the second trench 22 in dry oxygen of 950°C, 20 minutes, a gate insulating film 5 with a thickness of 2 to 3 nm is formed, or the CVD method, the sputtering method or the like is used to form a gate insulating film 5 comprising a high dielectric constant insulating film on the bottom surface of the second trench 22 (Fig. 1F).

Then, a gate G is formed by filling the inside of the trench with a two-layered structure of polysilicon and tungsten silicide or, using the CVD method, the sputter method or the like, with a metal 13 such as Tin or Mo, and is planarized through CMP or the like (Fig. 1G).

Finally, lead electrodes 14 of the source S and the drain D are formed, and a transistor 100A is obtained (Fig. 1H).

With the transistor 100A thus obtained, since the gate G is formed to protrude between the source S and the drain D into which impurities are introduced at a high concentration, the source S does not face the drain D, and a longer distance between the source S and the drain D can be secured as compared with the conventional trench gate type transistor. Therefore, the short channel effect can be suppressed effectively. Also, as compared with the conventional trench gate type transistor in which the insulating film between the source S or the drain D and the gate G is the gate insulating film 5 with a thickness of approximately 3 nm alone, according to this transistor 100A, because the side wall 21 comprising a relatively thick insulating film is provided, the capacitance between the source S or the drain D and the gate G can be reduced to approximately one-tenth or less. In addition, according to this method of manufacturing the transistor 100A, since the formation of the gate insulating film 5 and the gate G is performed after the thermal process for forming the source S and the drain D, direct tunnel currents can be prevented because it becomes easier to adopt a high dielectric constant insulating film as the material for the gate insulating film, while at the same time, degradation in the performance of the transistor due to depletion in the gate can be prevented because it becomes possible to form the gate with a metal.

In addition, since the second trench 22 is formed in a self-aligned manner with the side wall 21 with respect to the first trench 20, and a width L3 of the second trench 22 is formed narrower than the width L1 of the first trench 20, the width L3 of the second trench 22 is automatically formed with a width narrower than the lithography resolving power which defines the first trench 20. More specifically, for example, when the width L1 of the first trench 20 is made 0.18 µm and the width L2 of the side wall 21 is made 0.05 µm, the width L3 of the second trench 22 is formed at 0.08 µm. Therefore, according to the present invention, it is possible to form a miniaturized transistor with an extremely short gate length of 0.08 µm or below, which is considered difficult even with KrF lithography or ArF lithography that are currently in practical use.

For the trench gate type transistor 100A shown in Fig. 1A to Fig. 1H, the short channel effect can further be suppressed by forming a second impurity layer of a conductivity type equivalent to the impurity layer 9, which forms the source and the drain, in a section of the substrate deeper than the impurity layer 9 at approximately a fraction of the impurity concentration of the impurity layer 9 to provide an extended source and an extended drain.

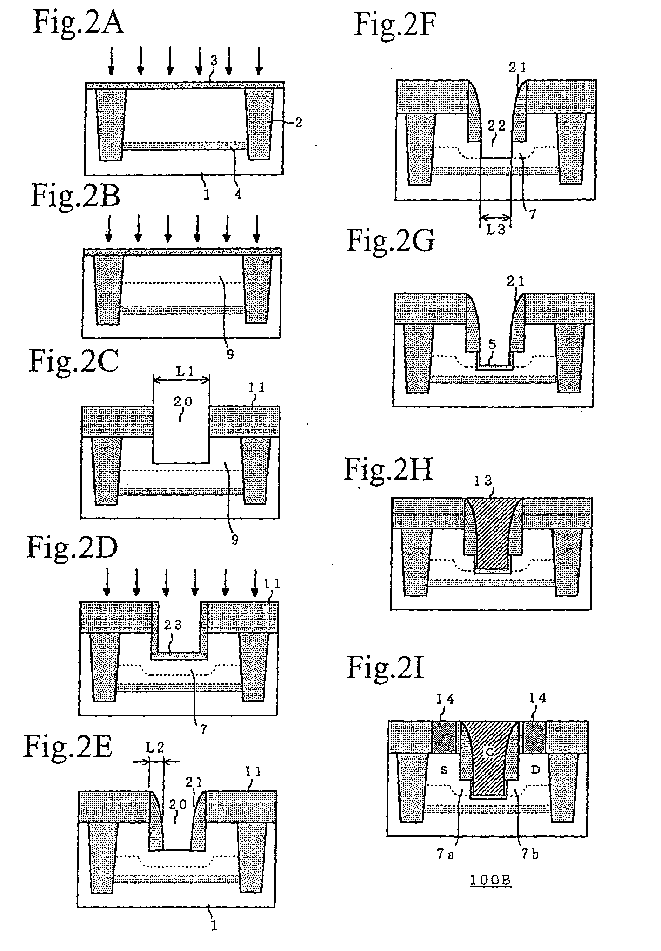

Fig. 2A to Fig. 2I are explanatory views of the manufacturing steps of a trench gate type MOS (MIS) transistor 100B in an embodiment of the present invention in which such an extended source and an extended drain are provided.

In this embodiment, much like the trench gate type transistor 100A shown in Fig. 1A to Fig. 1H, element separators 2, a through-film 3, a well 4, a Vₜₕ adjusting layer (not shown) are each formed in a p-type silicon substrate (Fig. 2A), and phosphorus, arsenic or the like, which are n-type impurities, is ion-implanted at a concentration of approximately 3 x 10¹⁵ cm⁻² at a depth of approximately 0.1 to 0.2 µm in an area in which a source S and a drain D are to be formed to form an impurity layer 9 (Fig. 2B).

Next, on the through-film 3, approximately 0.2 to 0.3 µm of an interlayer insulating film 11 of SiO₂ or the like is deposited with the CVD method or the like, and from thereabove, through, for example, lithography technology employing KrF laser or the like, a first trench 20 having a width L1 of approximately 0.18 µm is formed in substantially the middle between the element separators 2, penetrating the interlayer insulating film 11 and up to a depth shallower than the end of the profile of the impurity layer 9 by several ten nanometers (Fig. 2C).

A through-film 23 comprising SiO₂ is formed on the bottom surface and the side surfaces in the first trench 20 at a thickness of approximately several ten nanometers with a CVD method having good coverage. Next, the ion implantation method is again used to implant an impurity such as phosphorus or arsenic of the same conductivity type as the impurity layer 9 at a position deeper than the impurity layer 9 in the substrate 1, for example at a depth of approximately 40 to 50 nm from the bottom surface of the first trench 20, at approximately a fraction of the impurity concentration of the impurity layer 9, for example at approximately 1 x 10¹⁵ cm⁻², to form a second impurity layer 7 which is to form the extended source and the extended drain (Fig. 2D).

Annealing is performed thereon at 900°C for approximately 30 minutes in an electric furnace, or at 1050°C for approximately 10 seconds through a rapid heating method to activate the impurities implanted into the substrate 1 up to this point.

Next, the CVD method is combined with anisotropic etching to form a side wall 21 comprising an insulating material such as SiO₂ at a thickness L2 of approximately 0.05 µm on the side wall of the first trench 20, and the substrate 1 is exposed at the bottom surface of the first trench 20 (Fig. 2E).

By performing selective etching, with this side wall 21 as a mask, on the substrate 1 exposed at the bottom surface of the first trench 20, a second trench 22 is formed up to the depth of the end of the profile of the second impurity layer 7 or a depth deeper than the end by approximately several nanometers (Fig. 2F).

Next, by thermally oxidizing the bottom surface of the second trench 22 in dry oxygen of 950°C and approximately 20 minutes, a gate insulating film 5 with a thickness of 2 to 3 nm is formed, or a gate insulating film 5 comprising a high dielectric constant insulating film is formed on the bottom surface of the second trench 22 using the CVD method, the sputtering method or the like (Fig. 2G).

Then, a gate G is formed by filling the inside of the trench with a two-layered structure of polysilicon and tungsten silicide or by filling it, using the CVD method, sputtering method or the like, with a metal 13 such as Tin or Mo, and is planarized through CMP or the like (Fig. 2H).

Finally, lead electrodes 14 of the source S and the drain D are formed, and the transistor 100B is obtained (Fig. 2I).

In the transistor 100B thus obtained, since the source S and the drain D having high impurity concentrations are formed at positions shallower than the gate G, the distance between the source S and the drain D becomes even longer than that in the transistor 100A in Fig. 1A to Fig. 1H, and results in a structure in which the short channel effect is further suppressed. Also, since the extended source 7a and the extended drain 7b are formed up to substantially the same depth as the gate G, the reduction in the current driving capability is suppressed to a minimum.

Fig. 3A to Fig. 3I are explanatory views of the manufacturing steps for a trench gate type MOS (MIS) transistor 100C in an embodiment of the present invention which more effectively suppresses the short channel effect by providing an opposite conductivity type impurity layer (a so-called pocket or Halo) of a conductivity type opposite to an impurity layer, which forms a source or a drain, immediately below the source or the drain.

In this embodiment, as in the trench gate type transistor 100A shown in Fig. 1A to Fig. 1H, element separators 2, a through-film 3, a well 4, a Vₜₕ adjusting layer (not shown) are each formed in a p-type silicon substrate 1 (Fig. 3A). Further, in order to form an impurity layer 9, phosphorus, arsenic or the like, which are n-type impurities, is ion-implanted in an area in which a source S and a drain D are to be formed at a concentration of approximately 3 x 10¹⁵ cm⁻² at a depth of approximately 0.1 to 0.2 µm (Fig. 3B).

Next, an impurity such as boron of a conductivity type opposite to the impurity which forms the impurity layer 9 is ion-implanted at a position deeper than the impurity layer 9 by approximately 20 to 30 nm at a concentration of approximately 1 x 10¹³ cm⁻², and an opposite conductivity type impurity layer 24 is formed (Fig. 3C).

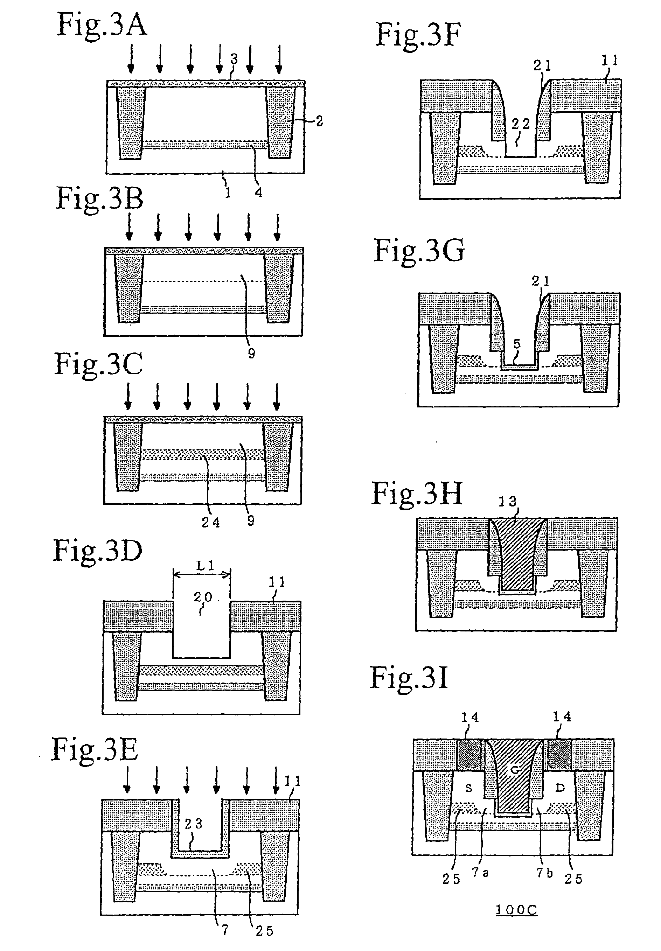

In addition, on the through-film 3, approximately 0.2 to 0.3 µm of an interlayer insulating film 11 of SiO₂ or the like is deposited with the CVD method or the like. From thereabove, for example, with lithography technology using KrF laser or the like, a first trench 20 having a width L1 of approximately 0.18 µm is formed in substantially the middle between the element separators 2, penetrating the interlayer insulating film 11, and down to the end of the profile of the impurity layer 9 or to a depth shallower than the end by several ten nanometers (Fig. 3D). A through-film 23 comprising SiO₂ is formed in a thickness of approximately several ten nanometers on the bottom surface and the side surfaces of the first trench 20 using a CVD method with a good coverage.

Next, the ion implantation method is again used to implant an impurity such as phosphorus or arsenic of the same conductivity type as the impurity layer 9 at a depth of approximately 40 to 50 nm from the bottom surface of the first trench 20 at a concentration of approximately 1 x 10¹⁵ cm⁻², and a second impurity layer 7, which is to form an extended source and an extended drain, is formed. Then, annealing is performed at 900°C for approximately 30 minutes in an electric furnace, or at 1050°C for approximately 10 seconds with a rapid heating method to activate the impurities implanted in the substrate 1 up to this point. As a result, sections adjacent immediately below and to the left and right of the first trench 20 become n-type layers by having the impurities of the opposite conductivity type impurity layer 24 compensated electrically upon activation, and pockets 25 are formed only immediately below sections in which the source S and the drain D are to be formed (Fig. 3E).

Thereafter, a second trench 22 is formed in a manner similar to the trench gate type transistor 100B shown in Fig. 2A to Fig. 2I (Fig. 3F), a gate insulating film 5 is formed (Fig. 3G), the trench is filled to form a gate G (Fig. 3H), and lead electrodes 14 are formed to obtain the trench gate type transistor 100C (Fig. 3I).

In this transistor 100C, due to the fact that the source S and the drain D having high impurity concentrations are formed at positions shallower than the gate G, the source S and the drain D do not face each other directly, and also the distance between them is increased, in addition to which, since the pocket 25, which suppresses the extension of the depletion layer, is formed immediately below the source S and the drain D, the short channel effect can be suppressed further than the transistor 100B in Fig. 2A to Fig. 2I.

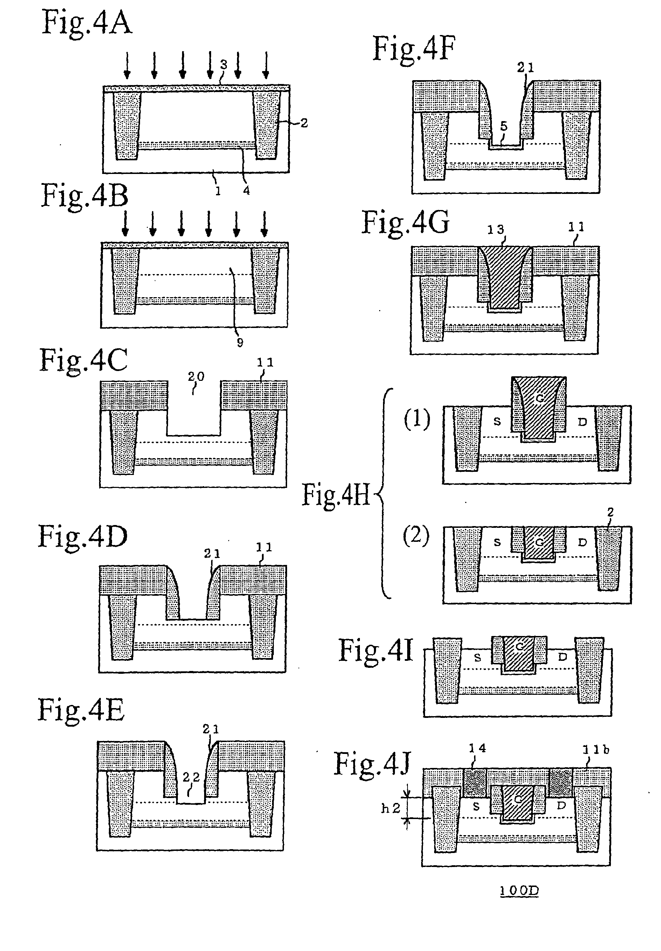

In the trench gate type transistor of the present invention, by having the thickness of the source and the drain recede, the area where the source and the drain face the gate can be decreased, and the capacitance between the source or the drain and the gate may thereby be decreased, and an increase in the speed of operation can be achieved. For example, as shown in Fig. 4A to Fig. 4J, with the structure of the trench gate type transistor 100A shown in Fig. 1A to Fig. 1H, a trench gate type transistor 100D, in which the area where the source and the drain face the gate is reduced, can be obtained.

Specifically, first, as in the trench gate type transistor 100A in Fig. 1A to Fig. 1H, a first trench 20 is formed in an impurity layer 9 formed in a substrate 1 (Fig. 4A to Fig. 4C), and a side wall 21 is formed on a side wall thereof (Fig. 4D). However, in the present embodiment, to differentiate the selectivity of etching of both the side wall 21 and an interlayer insulating film 11, the interlayer insulating film 11, for example, is formed with Si₃N₄, and the side wall 21 is formed with SiO₂.

Next, with the side wall 21 as a mask, a second trench 22 is formed (Fig. 4E), a gate insulating film 5 is formed (Fig. 4F), a metal 13 is embedded in the trench to form a gate G (Fig. 4G), and then, by performing selective etching, only the interlayer insulating film 11 comprising Si₃N₄ is selectively removed (Fig. 4H(1)). Normal Si etching is performed on the source S and the drain D exposed by the selective etching of the interlayer insulating film 11, and the thicknesses of the source S and the drain D are made to recede to a thickness at which low resistances thereof are not impaired, for example, to 50 nm at 200 ohms/square or below.

In order to prevent adverse effect on the gate G by the selective etching of the interlayer insulating film 11, it is desirable that the gate G be covered on top with a mask before the selective etching is performed. In addition, after the gate G is formed as shown in Fig. 4G, it is effective, as shown in Fig. 4H(2), to have the interlayer insulating film 11 recede, the side wall 21, and the gate G to the height of the element separators 2 through CMP or the like, and to sufficiently secure a space between the source S or the drain D and the gate G. On the source S and the drain D exposed by CMP or the like is performed normal Si etching as described above, and the thicknesses of the source S and the drain D are made to recede to a thickness at which the low resistances thereof are not impaired, for example, to 50 nm at 200 ohms/square or below (Fig. 4I).

Then, an interlayer insulating film 11b is again formed, lead electrodes 14 of the source S and the drain D are formed therein, and the trench gate type transistor 100D is obtained (Fig. 4J).

A thickness h2 of the source S and the drain D of the transistor 100D thus obtained is thinner than a thickness h1 of the source S and the drain D of the transistor 100A in Fig. 1A to Fig. 1H. Therefore, the capacitance between the source or the drain and the gate can be reduced to an approximately equivalent level as that of the conventional transistor 100X in Fig. 8A to Fig. 8I in which the source and the drain do not face each other at the sides of the gate.

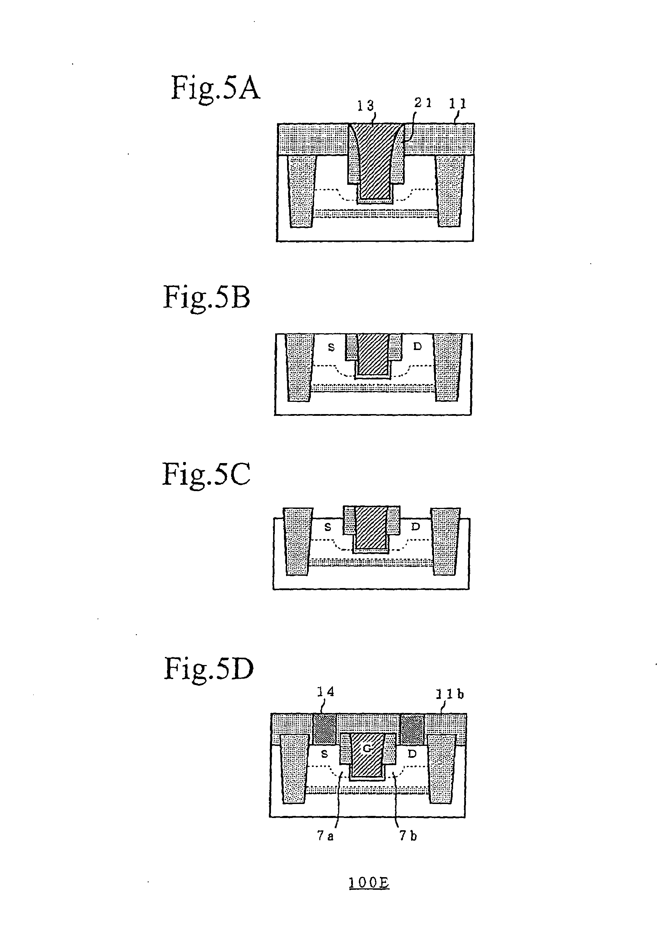

The reduction in capacitance between the source or the drain and the gate by having the thicknesses of the source and the drain recede in this manner can likewise be applied to each of the trench gate type transistors 100B and 100C shown in Fig. 2A to Fig. 2I and Fig. 3A to Fig. 3I. Specifically, when it is applied to the transistor 100B shown in Fig. 2A to Fig. 2I, after the metal 13 is embedded in the trench to form the gate G as shown in Fig. 2H (Fig. 5A), as shown in Fig. 5B, the interlayer insulating film 11, the side wall 21 and the gate G are made to recede to the height of the element separators 2 through CMP or the like beforehand, the thicknesses of the source S and the drain D are made to recede by further performing Si etching (Fig. 5C), the interlayer insulating film 11b is formed thereon, and lead electrodes 14 are formed therein, thereby obtaining a transistor 100E (Fig. 5D).

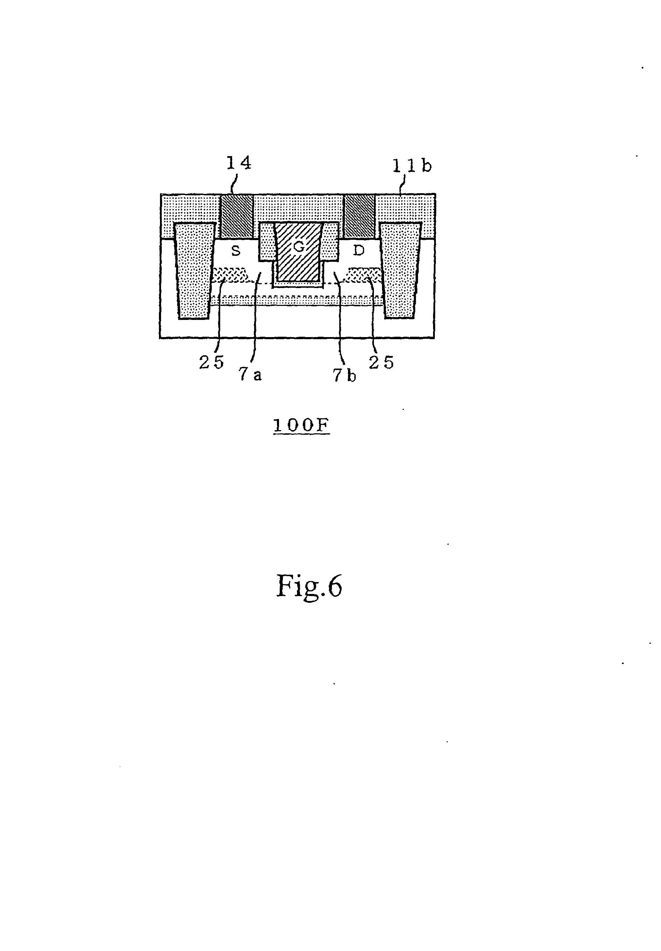

In addition, with the structure of the trench gate type transistor 100C shown in Fig. 3A to Fig. 3I, too, a trench gate type transistor 100F shown in Fig. 6 is obtained by making the thicknesses of the source and the gate recede in a similar manner.

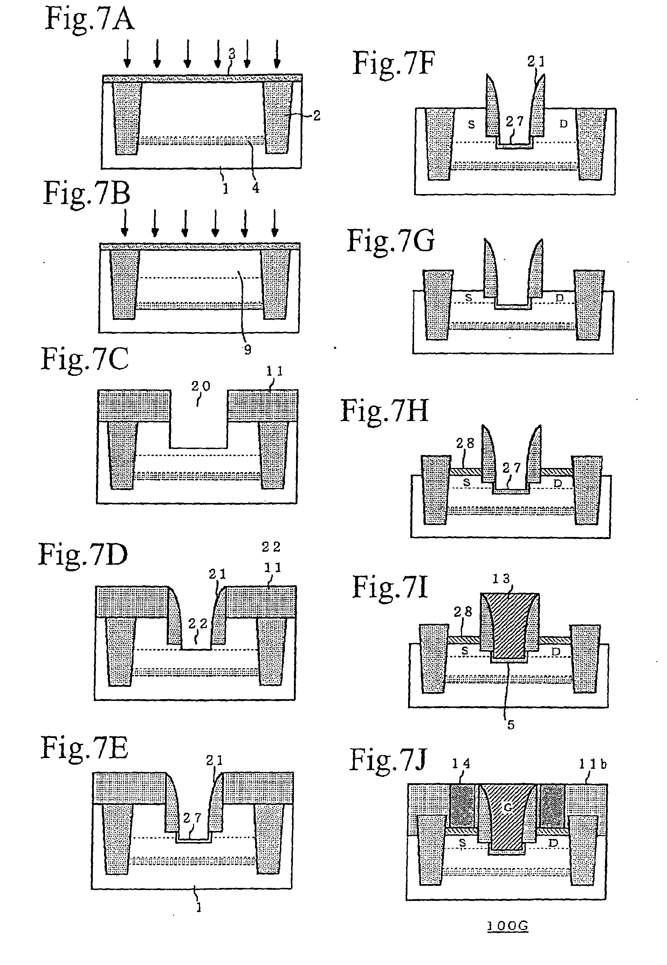

Fig. 7A to Fig. 7J are explanatory views of the manufacturing steps for a trench gate type transistor 100G in an embodiment in which the resistances of a source and a drain are reduced further than the trench gate type transistors in the aforementioned embodiments. In this embodiment, first, like the trench gate type transistor 100D shown in Fig. 4A to Fig. 4J, an interlayer insulating film 11 comprising Si₃N₄ is formed, a first trench 20 penetrating therethrough is formed (Fig. 7A to Fig. 7C), a side wall 21 is formed on the side wall of the first trench 20, and with that as a mask, a second trench 22 is formed (Fig. 7D).

Next, a sacrificial oxide film 27 is formed in a substrate 1 exposed at the bottom surface of the second trench 22 with, for example, thermal oxidation at 950°C for approximately 10 minutes (Fig. 7E).

Then, the interlayer insulating film 11 comprising Si₃N₄ is removed through selective etching to expose the surfaces of the source S and the drain D (Fig. 7F), and Si etching is further performed to reduce the thicknesses of the source S and the drain D (Fig. 7G).

On the source S and the drain D whose thicknesses are thus reduced, a metal such as Co or Ti is deposited, and a silicide 28 such as Co or Ti is formed through a normal silicide method (Fig. 7H).

Next, the sacrificial oxide film 27 is removed, and as a gate insulating film 5, either a high quality oxide film is formed through CVD or the like or a high dielectric constant insulating film of Al₂O₃ or the like is deposited. Thereafter, as in the aforementioned embodiments, the trench on the gate insulating film 5 is filled with a two-layered structure of polysilicon and tungsten silicide or a metal 13 is embedded to form a gate G (Fig. 7I). An interlayer insulating film 11b is formed thereon and lead electrodes 14 are formed therein to obtain the transistor 100G (Fig. 7J).

By forming the silicide such as Co or Ti on the thinly formed source S and the drain D, a high performance transistor in which the resistances of the source and the drain are reduced can be formed. It should be noted that, as the metal for forming the silicide on the source S and the drain D, any that can be formed as a thin film with low resistance and does not bring about leakage would suffice, and it is not limited to Co or Ti.

In addition, in contrast to the fact that in the embodiments shown in Fig. 4 to Fig. 4J, and Fig. 5A to Fig. 5D, the source S and the drain D are made to recede after the formation of the gate, in the embodiment shown in Fig. 7A to Fig. 7J, the source S and the drain D are made to recede after the provision of the sacrificial oxide film 27 (Fig. 7E) and before the formation of the gate G (Fig. 7I). However, in the present invention, the receding of the source S and the drain D may be made to recede by either mode.

The present invention can take various modes other than these. For example, while in the examples above, a manufacturing method for n-type MOS or MIS transistors have been described, by reversing the conductivity type of the substrate and the impurities, it can likewise be applied to a p-type transistor.

The metal used as the composition material for the gate or the high dielectric constant insulating film used as the gate insulating film is also not limited to the aforementioned examples. It is possible to select a metal with an appropriate work function or a high dielectric constant insulating material with an appropriate band gap which is a stable material with good moldability as deemed appropriate.

The thicknesses of the various films, the impurity concentrations, the depths of the impurity layers and the like, too, are not limited to the aforementioned examples, and can be optimized in accordance with the gate length, Vₜₕ, the current driving capability of the transistor to be formed, and other desired characteristics.

According to the trench gate type field effect transistor of the present invention, since the gate is formed to protrude between the source and the drain into which impurities are introduced at a high concentration, the source does not face the drain, and the distance between the source and the drain can be secured largely as compared with conventional trench gate type transistors. Therefore, the short channel effect can be suppressed effectively.

Also, as compared with conventional trench gate type transistors in which the insulating film between the source or the drain and the gate is a gate insulating film alone with a thickness of approximately 3 nm, because the side wall comprising the relatively thick insulating film is provided, it is possible to reduce the capacitance between the source or the drain and the gate to approximately one-tenth or less.

In addition, according to the manufacturing method for the trench gate type field effect transistor of the present invention, the formation of the gate insulating film and the gate can be performed after the thermal process for forming the source and the drain. Thus, a high dielectric constant insulating film can be employed as the material of the gate insulating film, and direct tunnel currents can be prevented, while at the same time, degradation of transistor performance due to depletion in the gate can be prevented since it also becomes possible to form the gate with a metal.

In addition, since the width of the second trench, which defines the gate length in the present invention, is shorter than the width of the first trench defined by the lithography resolving power, miniaturization of the transistor can be advanced more than the design rules defined by the lithography resolving power.

In particular, in the present invention, according to the mode in which the thicknesses of the source and the drain are made to recede, because the silicide can be formed on the source and the drain without increasing the area at which the source or the drain faces the gate, it is possible to simultaneously achieve a reduction in the capacitance between the source or the drain and the gate as well as a reduction in the resistances of the source and the drain.

In addition, according to the trench gate type field effect transistor of the present invention, as compared with conventional damascene gate transistors, manufacturing with fewer steps is possible, and a reduction in manufacturing costs can also be achieved.

## Claims

1. A trench gate type field effect transistor, comprising:
a side wall made of an insulating material and formed on a side wall of a first trench formed in a semiconductor substrate having an impurity layer;
a gate insulating film provided on a bottom surface of a second trench formed in a bottom surface of the first trench;
a gate formed so as to fill the first trench and the second trench; and
a source and a drain formed of said impurity layer and which face the gate via the side wall.

2. The trench gate type field effect transistor according to claim 1, wherein an extended source or an extended drain formed of a second impurity layer into which impurity is introduced at a concentration lower than the impurity layer forming the source or the drain is provided between the source or the drain and the gate insulating film.

3. The trench gate type field effect transistor according to claim 1 or 2, wherein an opposite conductivity type impurity layer of a conductivity type opposite to the impurity layer forming the source or the drain is formed immediately below the source or the drain.

4. The trench gate type field effect transistor according to any one of claims 1 to 3, wherein a silicide is deposited on the impurity layer forming the source or the drain.

5. A method of manufacturing a trench gate type field effect transistor **characterized in that**:
an impurity layer which is to be a source or a drain in a semiconductor substrate is formed;
a first trench is formed in said semiconductor substrate;
a side wall made of an insulating material is formed on a side wall of the first trench;
a second trench is formed in a bottom surface of the first trench with the side wall as a mask;
a gate insulating film is formed on a bottom surface of the second trench; and
a gate is formed so as to fill the second trench and the first trench.

6. The method of manufacturing a trench gate type field effect transistor according to claim 5, wherein the first trench is formed at a depth shallower than an end of a profile of the impurity layer, and the second trench is formed at a depth at the end of the profile of the impurity layer or a depth deeper than the end.

7. The method of manufacturing a trench gate type field effect transistor according to claim 5 or 6, wherein, after the first trench is formed, a second impurity layer of the same conductivity type as said impurity layer is formed in a section of the substrate deeper than said impurity layer with an impurity of a lower concentration than said impurity layer, and the second trench is formed in the second impurity layer.

8. The method of manufacturing a trench gate type field effect transistor according to claim 7, wherein an opposite conductivity type impurity layer of a conductivity type opposite to said impurity layer is formed in a section of the substrate deeper than said impurity layer, and the first trench is formed thereafter.

9. The method of manufacturing a trench gate type field effect transistor according to any one of claims 5 to 8, wherein the thickness of the impurity layer which is to be a source or a drain is made to recede after the gate is formed.

10. The method of manufacturing a trench gate type field effect transistor according to any one of claims 5 to 8, wherein the thickness of the impurity layer which is to be a source or a drain is made to recede after the second trench is formed, before the gate is formed.

11. The method of manufacturing a trench gate type field effect transistor according to claim 9 or 10, wherein a silicide is deposited on the source or the drain.

12. The method of manufacturing a trench gate type field effect transistor according to claim 10, wherein
after forming the second trench, a sacrificial oxide film is formed on the bottom surface of the second trench before the thickness of the impurity layer which is to be the source or the drain is made to recede,
a thermal treatment for activating the impurity in the impurity layer is performed,
the thickness of the impurity layer which is to be the source or the drain is made to recede, and
the sacrificial oxide film is then removed and the gate is formed.
